# EUROPÄISCHE PATENTSCHRIFT

(11) **EP 2 255 439 B1**
(45) Veröffentlichungstag und Bekanntmachung des Hinweises auf die Patenterteilung: **12.09.2018**
(21) Anmeldenummer: 09723107.0
(22) Anmeldetag: 16.03.2009
(51) Int. Cl.: H03K 17/12, G01R 19/25, G05F 1/59, H05B 39/02

(54) **VERFAHREN UND VORRICHTUNG ZUM BETREIBEN EINER SCHALTUNGSANORDNUNG**
METHOD AND DEVICE FOR OPERATING A CIRCUIT ARRANGEMENT
PROCÉDÉ ET DISPOSITIF D' UTILISATION D' UN CIRCUIT

(30) Priorität: 18.03.2008 DE 102008014677
(43) Veröffentlichungstag der Anmeldung: 01.12.2010
(73) Patentinhaber: Continental Automotive GmbH, 30165 Hannover (DE)
(72) Erfinder: JÄCKLE, Holger, 78087 Mönchweiler (DE)
(86) Internationale Anmeldenummer: PCT/EP2009/053058
(87) Internationale Veröffentlichungsnummer: WO 2009/115483

(56) Entgegenhaltungen:
- WO-A1-00/07415
- DE-A1- 10 258 766
- DE-A1- 19 812 920
- DE-A1-102004 045 435
- US-A1- 2003 160 578

## Beschreibung

Die Erfindung betrifft ein Verfahren zum Betreiben einer Schaltungsanordnung und entsprechende Schaltungsanordnung mit mehreren Schaltelementen, die ausgangsseitig zumindest einer vorgegebenen gemeinsamen Last zugeordnet sind und jeweils dazu ausgebildet sind, abhängig von einer Schaltstellung ein Nutzsignal an einem Ausgang des Schaltelements der zumindest einen gemeinsamen Last zur Verfügung zu stellen.

Derartige Schaltelemente sind beispielsweise Smart-Schaltelemente. Smart-Schaltelemente sind kurzschlussgeschützte Schaltelemente mit zumindest einem Schalter und einer dem zumindest einen Schalter zugeordneten Überwachungseinheit, die mittels einer thermischen Überwachung beim Führen eines Überlaststroms den Schalter ausschalten. Diese Smart-Schaltelemente umfassen beispielsweise zumindest einen Sensierungsausgang. Mittels des Sensierungsausgangs kann ein Sensorsignal, das beispielsweise als Sensorstrom ausgebildet ist, getrieben werden. Das Sensorsignal ist im Wesentlichen repräsentativ für einen Strom durch den ihm zugeordneten Schalter. Das Sensorsignal ist bevorzugt um einen vorgegebenen Faktor kleiner, so z. B. 1000, als der durch ihn repräsentierte Laststrom durch den Schalter.

Aus der DE 198 12 920 A1, welche in der DE 102 58 766 A1 zitiert wird ist eine Vorrichtung gemäß Oberbegriff des unabhängigen Vorrichtungsanspruch bekannt. Als nachteilig daran anzusehen ist der Aufwand der Meßeinrichtung im Betrieb.

Die Aufgabe, die der Erfindung zugrunde liegt, ist es, ein verbessertes Verfahren zum Betreiben einer Schaltungsanordnung und eine verbesserte Schaltungsanordnung anzugeben, das bzw. die sicher und zuverlässig ist.

Die Aufgabe wird gelöst durch die Merkmale der unabhängigen Patentansprüche. Vorteilhafte Ausgestaltungen der Erfindung sind in den Unteransprüchen gekennzeichnet.

Die Erfindung zeichnet sich aus durch ein Verfahren zum Betreiben einer Schaltungsanordnung und eine entsprechende Schaltungsanordnung mit mehreren Schaltelementen, die ausgangsseitig zumindest einer vorgegebenen gemeinsamen Last zugeordnet sind. Die Schaltelemente sind jeweils dazu ausgebildet, abhängig von einer Schaltstellung ein Nutzsignal an einem Ausgang des jeweiligen Schaltelements der zumindest einen gemeinsamen Last zur Verfügung zu stellen. In einem oder mehreren Ermittlungsdurchläufen wird zumindest eine Auswahl an eingeschalteten Schaltelementen zur Ansteuerung der zumindest einen gemeinsamen Last so lange verändert, bis ein dem jeweiligen Schaltelement zugeordnetes Sensorsignal, das repräsentativ ist für das Nutzsignal des jeweiligen Schaltelements, in einem ihm vorgegebenen Wertebereich liegt. Dabei wird diejenige zumindest eine Auswahl an eingeschalteten Schaltelementen ermittelt und gespeichert, bei der das jeweilige Sensorsignal in dem ihm vorgegebenen Wertebereich liegt.

Mittels der jeweiligen Ermittlung der Auswahl an eingeschalteten Schaltelementen kann das jeweilige Sensorsignal besonders zuverlässig dem ihm vorgegebenen Wertebereich vorgegeben werden. Dadurch wird eine Ermittlung des jeweiligen Sensorsignals besonders zuverlässig ermöglicht. Werte des jeweiligen Sensorsignals und des jeweiligen Nutzsignals können somit besonders exakt ermittelt werden.

Zur Ermittlung der jeweiligen Auswahl an eingeschalteten Schaltelementen können ein oder mehrere Ermittlungsdurchläufe erforderlich sein. Ist der Verlauf des Nutzsignals beispielsweise noch nicht auf einen vorgegebenen Wert eingeschwungen, so z. B. während eines Einschaltens des jeweiligen Schaltelements, können auch mehr als eine Auswahl an eingeschalteten Schaltelementen ermittelt und gespeichert werden. Dabei ist die jeweilige Auswahl bevorzugt einem vorgegebenen Zeitabschnitt zugeordnet und gewährleistet in diesem, dass das jeweilige Sensorsignal in dem ihm vorgegebenen Wertebereich liegt.

Bevorzugt kann die zumindest eine Auswahl an eingeschalteten Schaltelementen für eine vorgegebene Zeitdauer ermittelt werden. Bevorzugt umfasst die vorgegebene Zeitdauer denjenigen Verlauf des jeweiligen Nutzsignals, der noch nicht auf den vorgegebenen Wert eingeschwungen ist. Diese Zeitdauer kann beispielsweise vorgegeben werden oder dadurch ermittelt werden, dass die zumindest eine Auswahl an eingeschalteten Schaltelementen nur so lange erfolgt, bis sich die Werte des Nutzsignals nicht mehr ändern.

Der vorgegebene Wertebereich kann beispielsweise als Messbereich vorgegeben werden, so dass ein das Nutzsignal repräsentierendes Sensorsignal besonders genau und zuverlässig ermittelt werden kann, wenn dessen Werte in dem vorgegebenen Wertebereich liegen. Damit kann eine fehlerbehaftete gemeinsame Last besonders zuverlässig ermittelt werden und somit eine Schädigung der Schaltungsanordnung besonders sicher verhindert werden.

Gemäß einer vorteilhaften Ausgestaltung wird diejenige zumindest eine Auswahl an eingeschalteten Schaltelementen ermittelt und gespeichert, die einem vorgegebenen Zeitabschnitt bezüglich eines Startzeitpunkts der Ansteuerung der Schaltelemente zugeordnet ist.

Nach einem Einschalten der vorgegebenen gemeinsamen Last sind dem Sensorsignal und somit dem Nutzsignal typischerweise Signalverlaufsänderungen zugeordnet. Dabei können ein oder mehrere Auswahlmöglichkeiten an eingeschalteten Schaltelementen derart ermittelt werden, dass das jeweilige Sensorsignal in dem ihm zugeordneten Wertebereich liegt. Jede Auswahlmöglichkeit an eingeschalteten Schaltelementen ist bevorzugt einem vorgegebenen Zeitabschnitt bezüglich des Startzeitpunkts zugeordnet. Innerhalb des jeweiligen Zeitabschnitts liegt das Sensorsignal in dem ihm vorgegebenen Wertebereich. Eine derartige Ansteuerung der gemeinsamen Last gewährleistet somit eine besonders sichere und zuverlässige, sowie exakte Ermittlung des Sensorsignals und somit des durch ihn repräsentierten Nutzsignals.

Gemäß einer weiteren vorteilhaften Ausgestaltung wird die zumindest eine Auswahl an eingeschalteten Schaltelementen derart ermittelt, dass während eines ersten Ermittlungsdurchlaufs zunächst alle Schaltelemente eingeschaltet sind und das jeweilige Sensorsignal mit dem ihm zugeordneten Wertebereich verglichen wird und bei einem betragsmäßigen Unterschreiten des vorgegebenen Wertebereichs in zumindest einem weiteren Ermittlungsdurchlauf eine jeweilige Untermenge der Schaltelemente ausgeschaltet wird, bis das jeweilige Sensorsignal in dem ihm vorgegebenen Wertebereich liegt.

Dies hat den Vorteil, dass besonders einfach und zuverlässig zumindest eine Auswahlmöglichkeit an eingeschalteten Schaltelementen ermittelt werden kann.

Gemäß einer weiteren vorteilhaften Ausgestaltung wird die zumindest eine Auswahl an eingeschalteten Schaltelementen derart vorgegeben, dass während eines ersten Ermittlungsdurchlaufs zunächst ein Schaltelement eingeschaltet ist und das jeweilige Sensorsignal mit dem ihm zugeordneten Wertebereich verglichen wird und bei einem betragsmäßigen Überschreiten des vorgegebenen Wertebereichs in zumindest einem weiteren Ermittlungsdurchlauf eine jeweilige Untermenge der Schaltelemente eingeschaltet wird, bis das jeweilige Sensorsignal in dem ihm vorgegebenen Wertebereich liegt.

Dies hat den Vorteil, dass besonders einfach und zuverlässig zumindest eine Auswahlmöglichkeit an eingeschalteten Schaltelementen ermittelt werden kann.

Gemäß einer weiteren vorteilhaften Ausgestaltung wird ein der jeweiligen Auswahl an eingeschalteten Schaltelementen zugeordneter Verlauf des Sensorsignals ermittelt und gespeichert, der repräsentativ ist für die zumindest eine vorgegebene gemeinsame Last.

Neben der zumindest einen Auswahl an eingeschalteten Schaltelementen kann derjenige Verlauf des Sensorsignals ermittelt und gespeichert werden, der die gemeinsame Last repräsentiert. Der die zumindest eine gemeinsame Last repräsentierende gespeicherte Verlauf des Sensorsignals ist beispielsweise einem Zeitabschnitt bezüglich des Startzeitpunktes der Ansteuerung zugeordnet. Bei einem Betrieb der gemeinsamen Last kann diese mittels der Ermittlung des Verlaufs des Sensorsignals besonders einfach und zuverlässig erkannt werden. Nach der Erkennung der zumindest einen vorgegebenen gemeinsamen Last kann eine Ansteuerung der Schaltelemente gemäß der zumindest einen Auswahl an eingeschalteten Schaltelementen erfolgen, die dem gespeicherten Verlauf des Sensorsignals zugeordnet ist, durch welche die vorgegebene gemeinsame Last repräsentiert wird.

Gemäß einer weiteren vorteilhaften Ausgestaltung wird ein aktuell ermittelter Verlauf des Sensorsignals mit dem zumindest einen gespeicherten Verlauf des Sensorsignals verglichen, wobei der zumindest eine gespeicherte Verlauf des Sensorsignals repräsentativ ist für die zumindest eine vorgegebene gemeinsame Last. Abhängig von dem Vergleich wird die zumindest eine vorgegebene gemeinsame Last erkannt.

Mittels des Vergleichs des aktuell ermittelten Verlaufs des Sensorsignals mit dem zumindest einen gespeicherten Verlauf des Sensorsignals kann besonders einfach und zuverlässig die zumindest eine vorgegebene gemeinsame Last erkannt werden. Nach der Erkennung der zumindest einen gemeinsamen Last kann dieser die zumindest eine Auswahl an eingeschalteten Schaltelementen zugeordnet werden, die wiederum dem gespeicherten Verlauf des Sensorsignals zugeordnet ist. Dadurch kann ein zuverlässiger und sicherer Betrieb der zumindest einen gemeinsamen Last gewährleistet werden. Ferner kann eine fehlerbehaftete gemeinsame Last schnell und sicher detektiert und eine Schädigung der Schaltungsanordnung zuverlässig vermieden werden.

Ausführungsbeispiele der Erfindung sind im Folgenden anhand der schematischen Zeichnungen näher erläutert. Es zeigen:
- Figur 1: eine Schaltungsanordnung mit mehreren Schaltelementen,
- Figur 2: eine erste zeitliche Darstellung eines Sensorsignals bei einer ersten vorgegebenen gemeinsamen Last,
- Figur 3: eine zweite zeitliche Darstellung eines Sensorsignals bei einer ersten vorgegebenen gemeinsamen Last,
- Figur 4: eine dritte zeitliche Darstellung eines Sensorsignals bei einer ersten vorgegebenen gemeinsamen Last,
- Figur 5: eine erste zeitliche Darstellung eines Sensorsignals bei einer zweiten vorgegebenen gemeinsamen Last,
- Figur 6: eine zweite zeitliche Darstellung eines Sensorsignals bei einer zweiten vorgegebenen gemeinsamen Last,
- Figur 7: eine dritter zeitliche Darstellung eines Sensorsignals bei einer zweiten vorgegebenen gemeinsamen Last,
- Figur 8: eine vierte zeitliche Darstellung eines Sensorsignals bei einer zweiten vorgegebenen gemeinsamen Last.

Elemente gleicher Konstruktion oder Funktion sind figurenübergreifend mit dem gleichen Bezugszeichen gekennzeichnet.

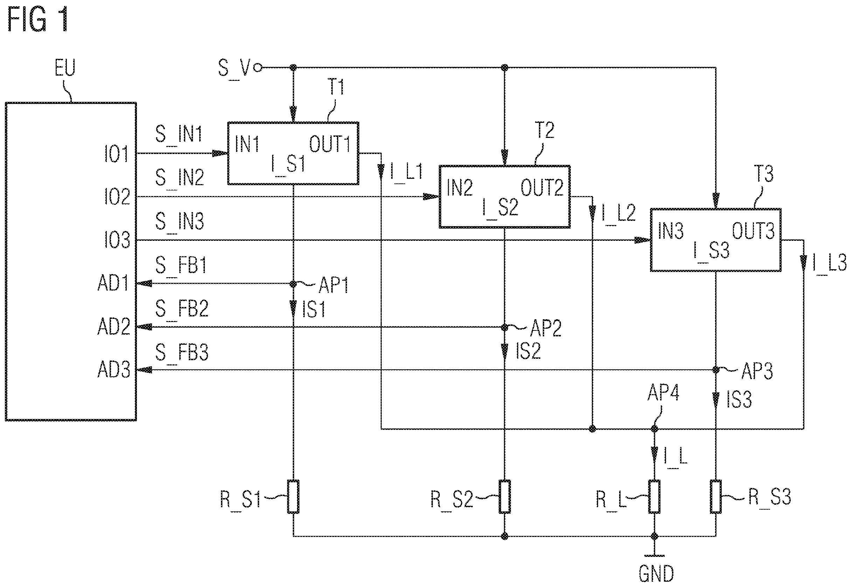

In Figur 1 ist eine Schaltungsanordnung mit einem ersten Schaltelement T1, einem zweiten Schaltelement T2 und einem dritten Schaltelement T3 dargestellt. Das erste, zweite und dritte Schaltelement T1, T2 und T3 sind beispielsweise als Smart-Schaltelemente ausgebildet und umfassen jeweils eine Überwachungseinheit und einen Schalter. Die Überwachungseinheit ist jeweils beispielsweise als thermische Überwachung ausgebildet. Die Schaltelemente T1, T2 und T3 sind einem Eingangssignal S_V zugeordnet, das beispielsweise als eine Versorgungsspannung eines Bordnetzes eines Kraftfahrzeugs ausgebildet ist. Der dem jeweiligen Schaltelement zugeordnete Schalter ist jeweils beispielsweise als Feldeffekttransistor ausgebildet und bevorzugt zwischen dem Anschluss des Eingangssignals S_V und einem dem jeweiligen Schaltelement zugeordneten Lastausgang angeordnet. Grundsätzlich sind aber auch andere einem Fachmann bekannte Ausführungen der Schaltelemente denkbar.

Die Schaltelemente können beispielsweise separat ausgeführt sein oder in einer gemeinsamen Schalteinheit integriert sein.

Ferner ist in Figur 1 eine Ausführungseinheit EU dargestellt. Die Ausführungseinheit EU ist dazu ausgebildet ein Verfahren zum Betreiben der Schaltungsanordnung abzuarbeiten. Die Ausführungseinheit EU umfasst einen ersten Eingabe-Ausgabe-Ausgang IO1, einen zweiten Eingabe-Ausgabe-Ausgang IO2 und einen dritten Eingabe-Ausgabe-Ausgang IO3. Dem ersten Eingabe-Ausgabe-Ausgang IO1 ist ausgangsseitig ein erstes Steuersignal S_IN1 zugeordnet. Dem zweiten Eingabe-Ausgabe-Ausgang IO2 ist ausgangsseitig ein zweites Steuersignal S_IN2 zugeordnet und dem dritten Eingabe-Ausgabe-Ausgang IO3 ist ausgangsseitig ein drittes Steuersignal S_IN3 zugeordnet. Das erste Steuersignal S_IN1 ist eingangsseitig dem ersten Schalteingang IN1 des ersten Schaltelements T1 zugeordnet. Das zweite Steuersignal S_IN2 ist eingangsseitig dem zweiten Schalteingang IN2 des zweiten Schaltelements T2 zugeordnet. Das dritte Steuersignal S_IN3 ist eingangsseitig dem dritten Schalteingang IN3 des dritten Schaltelements T3 zugeordnet. Der erste, zweite und dritte Eingabe-Ausgabe-Ausgang IO1, IO2 und IO3 der Ausführungseinheit EU weisen, wenn sie als Ausgang konfiguriert sind, beispielsweise jeweils entweder einen High-Pegel oder einen Low-Pegel auf, so z. B. 3,3 V für einen High-Pegel oder 0 V für einen Low-Pegel, die mittels der Ausführungseinheit EU unabhängig voneinander vorgegeben werden können. Mittels des ersten Steuersignals S_IN1 kann die Ausführungseinheit EU das erste Schaltelement T1 bei Nicht-Überlast beliebig ein- oder ausschalten. Mittels des zweiten Steuersignals S_IN2 kann die Ausführungseinheit EU das zweite Schaltelement T2 bei Nicht-Überlast beliebig ein- oder ausschalten. Mittels des dritten Steuersignals S_IN3 kann die Ausführungseinheit EU das dritte Schaltelement T3 bei Nicht-Überlast beliebig ein- oder ausschalten. Das erste, zweite und dritte Schaltelement T1, T2 und T3 können somit unabhängig voneinander mittels der Ausführungseinheit EU angesteuert werden.

Der Ausführungseinheit EU ist ferner eingangsseitig an einem ersten Analog-Digital-Wandler-Eingang AD1 ein erstes Sensorsignal S_FB1 zugeordnet. Das erste Sensorsignal S_FB1 wird an einem ersten Abgriffspunkt AP1, der einem ersten Sensierungsausgang I_S1 des ersten Schaltelements T1 und dem ersten Schaltelement T1 zugewandten Ende eines ersten Shunt-Widerstandes R_S1 zugeordnet ist, abgegriffen. Das erste Sensorsignal S_FB1 ist repräsentativ für einen als Nutzsignal ausgebildeten ersten Laststrom I_L1. Analog zum ersten Sensorsignal S_FB1 wird ein zweites Sensorsignal S_FB2 an einem zweiten Abgriffspunkt AP2 abgegriffen. Ein drittes Sensorsignal S_FB3 wird an einem dritten Abgriffspunkt AP3 abgegriffen. Der zweite Abgriffspunkt AP2 ist einem zweiten Sensierungsausgang I_S2 des zweiten Schaltelements T2 und dem zweiten Schaltelement T2 zugewandten Ende eines zweiten Shunt-Widerstandes R_S2 zugeordnet. Der dritte Abgriffspunkt AP3 ist einem dritten Sensierungsausgang I_S3 des dritten Schaltelements T3 und dem dritten Schaltelement T3 zugewandten Ende eines dritten Shunt-Widerstandes R_S3 zugeordnet. Das zweite Sensorsignal S_FB2 bzw. das dritte Sensorsignal S_FB3 sind einem zweiten Analog-Digital-Wandler-Eingang AD2 bzw. einem dritten Analog-Digital-Wandler-Eingang AD3 der Ausführungseinheit EU zugeordnet. Das zweite Sensorsignal S_FB2 bzw. das dritte Sensorsignal S_FB3 ist somit repräsentativ für einen als Nutzsignal ausgebildeten zweiten Laststrom I_L2 bzw. einen dritten Laststrom I_L3.

Der erste, zweite und dritte Analog-Digital-Wandler-Eingang AD1, AD2 und AD3 sind bevorzugt einem Analog-Digital-Wandler der Ausführungseinheit EU zugeordnet. Mittels des Analog-Digital-Wandlers der Ausführungseinheit EU können Werte analoger Signale, wie beispielsweise dem ersten, zweiten und dritten Sensorsignal S_FB1, S_FB2 und S_FB3, in digitale Werte umgewandelt werden, so dass diese mittels der Ausführungseinheit EU, die beispielsweise als Mikrokontroller und somit als digitale Ausführungseinheit ausgebildet ist, weiterverarbeitet werden können. Der erste, zweite und dritte Analog-Digital-Wandler-Eingang AD1, AD2 und AD3 können grundsätzlich aber auch unterschiedlichen Analog-Digital-Wandlern der Ausführungseinheit EU zugeordnet sein.

Neben den drei Analog-Digital-Wandler-Eingängen ist es grundsätzlich auch möglich, das erste, zweite und dritte Sensorsignal S_FB1, S_FB2 und S_FB3 einem gemeinsamen Multiplexer eingangsseitig zu zuführen. Dem Multiplexer ist ausgangsseitig ein Analog-Digital-Wandler-Eingang der Ausführungseinheit EU zugeordnet. Ferner sind dem Multiplexer eingangsseitig zwei Ansteuersignale zugeführt, die mittels der Ausführungseinheit EU angesteuert werden können. Abhängig von einer vorgegebenen Ansteuerung der Ausführungseinheit EU, wird das der Ansteuerung zugeordnet Sensorsignal mittels des Multiplexers ausgewählt und mittels einer Analog-Digital-Wandlung ermittelt. Diese Anordnung hat den Vorteil, dass nur ein Analog-Digital-Wandler-Eingang der Ausführungseinheit EU benötigt wird und mittels des Multiplexers besonders viele Sensorsignale dem einen Analog-Digital-Wandler-Eingang zugeführt werden können.

Einem dem ersten Schaltelement T1 abgewandten Ende des ersten Shunt-Widerstands R_S1 ist ein Bezugspotential GND zugeordnet. Ferner ist einem dem zweiten Schaltelement T2 abgewandten Ende des zweiten Shunt-Widerstands R_S2 das Bezugspotential GND zugeordnet. Einem dem dritten Schaltelement T3 abgewandten Ende des dritten Shunt-Widerstands R_S3 ist das Bezugspotential GND zugeordnet. Das Bezugspotential GND ist beispielsweise als Masse des Kraftfahrzeugs ausgebildet.

Grundsätzlich kann die Ausführungseinheit auch mehr als drei Eingabe-Ausgabe-Ausgänge und mehr als drei Analog-Digital-Wandler Eingänge umfassen und somit mehr als drei Schaltelemente ansteuern. Bevorzugte Schaltungsanordnungen umfassen bis zu acht Schaltelemente, die mittels der Ausführungseinheit EU unabhängig voneinander angesteuert werden und zumindest einer vorgegebenen gemeinsamen Last R_L zugeordnet sind.

Grundsätzlich können aber auch mehr oder weniger Schaltelemente angesteuert werden.

Ausgangsseitig sind das erste, das zweite und das dritte Schaltelement T1, T2 und T3 einem ersten Ende der zumindest einen vorgegebenen gemeinsamen Last R_L an einem vierten Abgriffspunkt AP4 zugeordnet. Dabei ist das erste Schaltelement T1 mittels eines ersten Lastausgangs OUT1, das zweite Schaltelement T2 mittels eines zweiten Lastausgangs OUT2 und das dritte Schaltelement T3 mittels eines dritten Lastausgangs OUT3 mit dem ersten Ende der gemeinsamen Last R_L gekoppelt.

Ein zweites Ende der gemeinsamen vorgegebenen Last R_L ist dem Bezugspotential GND zugeordnet.

Bei eingeschaltetem Schalter des jeweiligen Schaltelements ist eine elektrische Koppelung zwischen dem Anschluss des Eingangssignals V_IN und dem jeweiligen Lastausgang bevorzugt niederohmig geschaltet. Bei ausgeschaltetem Schalter des jeweiligen Schaltelements ist die elektrische Koppelung des Eingangssignals V_IN zum jeweiligen Lastausgang hochohmig geschaltet.

Die vorgegebene gemeinsame Last R_L ist beispielsweise als Glühlampe des Kraftfahrzeugs ausgebildet. Die Glühlampe ist beispielsweise als Leuchtmittel in einem Scheinwerfer des Kraftfahrzeugs oder als Leuchtmittel einer Innenraumbeleuchtung des Kraftfahrzeugs ausgebildet. Grundsätzlich kann die gemeinsame Last auch mehr als eine Last, so z. B. mehrere Glühlampen, repräsentieren, die dann bevorzugt elektrisch parallel angeordnet sind. In einem Betrieb der gemeinsamen Last R_L ist dieser ein gemeinsamer Laststrom I_L zugeordnet, der mittels des ersten und/oder zweiten und/oder dritten Schaltelements T1 und/oder T2 und/oder T3 zugeführt wird. Bei eingeschaltetem erstem Schaltelement T1 ist der zumindest einen gemeinsamen Last R_L eingangsseitig der erste Laststrom I_L1 zugeordnet. Bei eingeschaltetem zweitem Schaltelement T2 ist der zumindest einen gemeinsamen Last R_L eingangsseitig der zweite Laststrom I_L2 zugeordnet. Bei eingeschaltetem drittem Schaltelement T3 ist der zumindest einen gemeinsamen Last R_L eingangsseitig der dritte Laststrom I_L3 zugeordnet. In dem vierten Abgriffspunkt AP4 addieren sich der erste, zweite und dritte Laststrom I_L1, I_L2 und I_L3 zu dem gemeinsamen Laststrom I_L.

Zum Betreiben der vorgegebenen gemeinsamen Last R_L sind unterschiedliche Ansteuerkombinationen mittels der Schaltelemente T1, T2 und T3 möglich.

Beispielsweise sind einer ersten Ansteuerkombination ein eingeschaltetes Schaltelement und zwei ausgeschaltete Schaltelemente zugeordnet, so z. B. ein eingeschaltetes erstes Schaltelement T1, ein ausgeschaltetes zweites Schaltelement T2 und ein ausgeschaltetes drittes Schaltelement T3. Dabei ist dem gemeinsamen Laststrom I_L im Wesentlichen nur der Laststrom des eingeschalteten Schaltelements zugeordnet, so z. B. der erste Laststrom I_L1 des ersten Schaltelements T1. In der ersten Ansteuerkombination ist der Laststrom des eingeschalteten Schaltelements im Wesentlichen identisch zu dem gemeinsamen Laststrom I_L ausgebildet. Die Werte des den Laststrom repräsentierenden Sensorsignals des eingeschalteten Schaltelements sind somit besonders hoch ausgebildet und sind im Wesentlichen identisch mit den Werten des gemeinsamen Laststroms I_L.

Einer zweiten Ansteuerkombination sind beispielsweise zwei eingeschaltete Schaltelemente und ein ausgeschaltetes Schaltelement zugeordnet, so z. B. ein eingeschaltetes erstes und zweites Schaltelement T1 und T2 und ein ausgeschaltetes drittes Schaltelement T3. Dabei ist dem gemeinsamen Laststrom I_L der Laststrom der beiden eingeschalteten Schaltelemente zugeordnet, so z. B. der erste und zweite Laststrom I_L1 und I_L2. Bei dieser Ansteuerkombination sind die Werte des Laststroms des jeweilig eingeschalteten Schaltelements bevorzugt niedriger ausgebildet als die Werte des jeweiligen Laststroms bei erster Ansteuerkombination.

Einer dritten Ansteuerkombination sind beispielsweise drei eingeschaltete Schaltelemente zugeordnet, so z. B. ein eingeschaltetes erstes, zweites und drittes Schaltelement T1, T2 und T3. Dabei ist dem gemeinsamen Laststrom I_L der Laststrom aller drei Schaltelemente zugeordnet. In der dritten Ansteuerkombination teilt sich der gemeinsame Laststrom I_L also auf die drei Lastströme des ersten, zweiten und dritten Schaltelements T1, T2 und T3 auf. Bei identischer Ausführung der drei Schaltelemente T1, T2 und T3 sind die Beträge des ersten, zweiten und dritten Laststroms I_L1, I_L2 und I_L3 bevorzugt identisch ausgebildet, allerdings niedriger als der jeweilige Laststrom des jeweiligen Schaltelements bei der ersten und zweiten Ansteuerkombination.

Neben den hier beispielhaft dargestellten eingeschalteten und ausgeschalteten Schaltelemente können grundsätzlich auch jeweils andere Schaltelemente ein- oder ausgeschaltet sein.

Durch eine entsprechende Auswahl der Ansteuerkombination der Schaltelemente können Werte des den jeweiligen Laststrom repräsentierenden Sensorsignals in ihrer Höhe variiert werden. Durch ein Einschalten zusätzlicher Schaltelemente wird der Wert des jeweiligen Sensorsignals verringert und durch ein Ausschalten zusätzlicher Schaltelemente wird der Wert des jeweiligen Sensorsignals erhöht. Wird für die Werte des jeweiligen Sensorsignals ein jeweiliger Wertebereich vorgegeben, so können durch eine Veränderung der Ansteuerkombination die Werte des jeweiligen Sensorsignals derart beeinflusst werden, dass dessen Werte in dem ihm vorgegebenen Wertebereich liegen. Die jeweilige Ansteuerkombination repräsentiert somit eine vorgegebene Auswahl an eingeschalteten Schaltelementen.

In diesem Zusammenhang sei darauf hingewiesen, dass bei Laststrommessungen einer vorgegebenen gemeinsamen Last ein vorgegebener Messbereich mit einer möglichst hohen Messgenauigkeit vorgegebenen wird, um eine optimale Überwachung der zumindest einen vorgegebenen gemeinsamen Last und somit einen optimalen Schutz vor Überlast gewährleisten zu können. Ist beispielsweise nur die erste Ansteuerkombination vorgegeben, so fließt bei einer kleinen Strombelastung des jeweiligen Schaltelementes nur ein kleiner Laststrom durch das jeweilig eingeschaltete Schaltelement. Bei einer großen Strombelastung fließt beispielsweise ein großer Laststrom durch das jeweilig eingeschaltete Schaltelement. Eine jeweilige Überwachung des jeweiligen Laststroms erfolgt bevorzugt mittels einer Ermittlung des jeweiligen Sensorsignals, das repräsentativ ist für den jeweiligen Laststrom. Ist also nur die erste Ansteuerkombination zur Ansteuerung der vorgegebenen gemeinsamen Last vorgegeben, so müssen mittels des einen eingeschalteten Schaltelements die der kleinen Strombelastung zugeordneten Ströme und die der großen Strombelastung zugeordneten Ströme auf eine mögliche Überlast überwacht werden. Um somit eine Überwachung der gemeinsamen Last bei kleiner und großer Strombelastung gerecht zu werden, steht im Wesentlichen nur ein Messbereich mit eingeschränkter Messgenauigkeit zur Verfügung, wodurch eine genaue Überwachung der zumindest einen gemeinsamen Last R_L im Wesentlichen nicht gewährleistet ist. Durch die Verwendung mehrerer Schaltelemente, die, wie in Figur 1 dargestellt, parallel angesteuert werden können, kann für die jeweilige vorgegebene gemeinsame Last ein geeigneter Messbereich mittels der Veränderung der Ansteuerkombinationen während der Ansteuerung der zumindest einen gemeinsamen Last R_L zur Verfügung gestellt werden. Dies ist besonders dann vorteilhaft, wenn auch die gemeinsame Last unterschiedlich ausgebildet sein kann.

Damit allerdings der geeignete Wertebereich mit geeigneter Messgenauigkeit dem jeweiligen Schaltelement vorgegeben werden kann, muss die jeweilige gemeinsame Last zunächst zuverlässig erkannt werden.

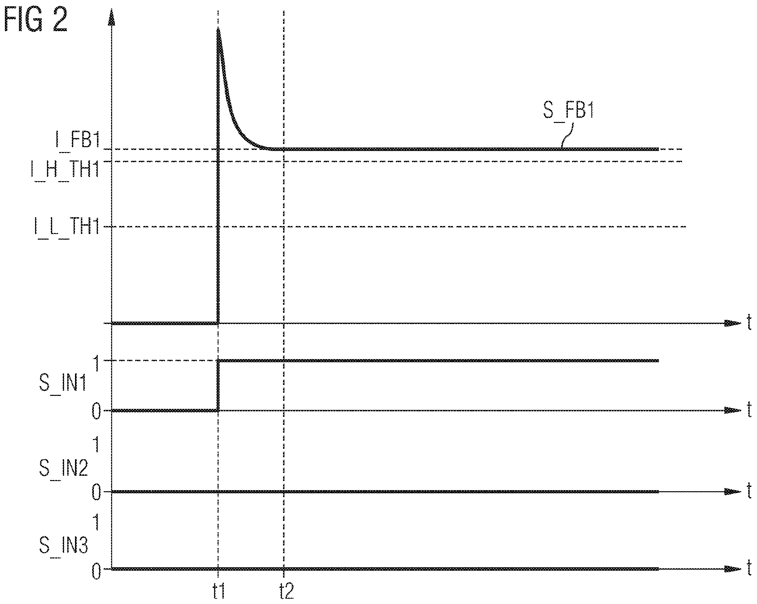

In Figur 2 ist die erste Ansteuerkombination von Schaltelementen dargestellt. Es zeigt einen zeitlichen Verlauf des ersten, zweiten und dritten Steuersignals S_IN1, S_IN2 und S_IN3 und des ersten Sensorsignals S_FB1. Als eingeschaltetes Schaltelement ist in Figur 2 beispielsweise das erste Schaltelement T1 dargestellt, wobei grundsätzlich auch ein anderes Schaltelement als das eingeschaltete Schaltelement der ersten Ansteuerkombination ausgebildet sein kann. Der zeitliche Verlauf des ersten Sensorsignals S_FB1 repräsentiert einen Verlauf des ersten Laststroms I_L1 durch das erste Schaltelement T1. Entsprechend der ersten Ansteuerkombination ist nur das erste Schaltelement T1 eingeschaltet, während das zweite und dritte Schaltelement T2 und T3 ausgeschaltet sind. Der Verlauf des ersten Sensorsignals S_FB1 repräsentiert somit im Wesentlichen den Verlauf des gemeinsamen Laststromes I_L durch die vorgegebene gemeinsame Last R_L, die in Figur 2 beispielsweise als Glühlampe ausgebildet ist.

Zu einem Einschaltzeitpunkt t1 wird das erste Schaltelement T1 mittels des ersten Steuersignals S_IN1 eingeschaltet. Der Verlauf des ersten Sensorsignals S_FB1 repräsentiert beginnend zum Einschaltzeitpunkt t1 einen Verlauf eines Einschaltstroms der als Glühlampe ausgebildeten gemeinsamen Last R_L. Bei einer anderen gemeinsamen Last R_L kann der Verlauf des ersten Sensorsignals S_FB1 entsprechend verändert verlaufen.

Der Verlauf des ersten Sensorsignals S_FB1 nähert sich beispielsweise einem ersten vorgegebenen Sensorsignalwert I_FB1 und ist ab einem Zeitpunkt t2 auf diesen Wert eingeschwungen.

Dabei ist darauf hinzuweisen, dass der erste Sensorsignalwert I_FB1 auf das erste Sensorsignal S_FB1 bezogen ist und ein durch den ersten Sensorsignalwert I_FB1 repräsentierter Wert des ersten Laststroms I_L1 um den vorgegebenen Faktor größer ist, so z. B. um den Faktor 1000.

Ein dem jeweiligen Sensorsignal zugeordneter Wertebereich des eingeschalteten Sensorsignals wird jeweils durch einen unteren Grenzsensorsignalwert und einen oberen Grenzsensorsignalgrenzwert vorgegeben. Beispielsweise ist der dem ersten Schaltelement T1 zugeordnete Wertebereich mittels eines ersten unteren Grenzsensorsignalwerts I_L_TH1 und eines ersten oberen Grenzsensorsignalgrenzwerts I_H_TH1 vorgegeben. Der untere und der obere Grenzsensorsignalwert repräsentieren einen Wertebereich, der auch als Messbereich mit geeigneter Messgenauigkeit ausgebildet sein kann. Beispielsweise repräsentiert der dem jeweiligen Schaltelement zugeordnete Wertebereich im Wesentlichen einen Sensorsignalbereich des Schaltelements innerhalb dessen eine genaue und sichere Repräsentation des jeweiligen Laststroms mittels des Sensorsignals gewährleistet ist.

Wie anhand der Figur 2 dargestellt ist, liegt der Verlauf des ersten Sensorsignals S_FB1 nach dem Einschaltzeitpunkt t1 betragsmäßig über dem ersten oberen Grenzsensorsignalgrenzwert I_H_TH1 und somit außerhalb des dem ersten Sensorsignal S_FB1 zugeordneten Wertebereichs. Außerhalb des vorgegebenen Wertebereichs können jeweilige Werte des Verlaufs des ersten Sensorsignals S_FB1 zwar mittels einer Analog-Digital-Wandlung ermittelt werden, allerdings nur mit eingeschränkter Messgenauigkeit.

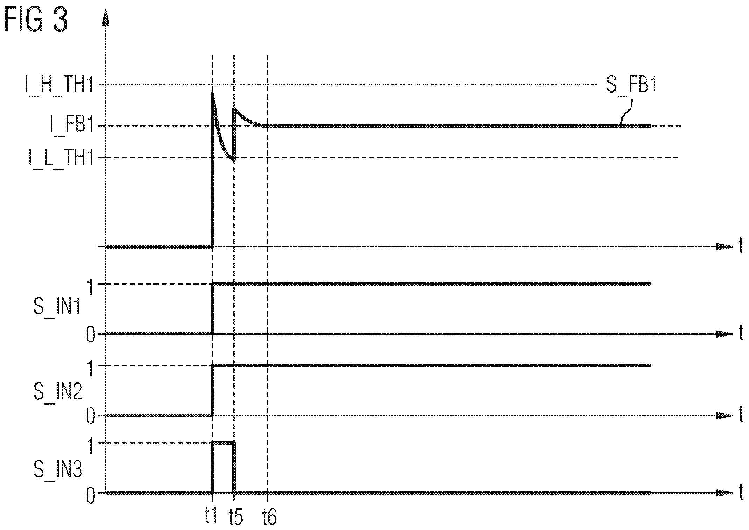

Anhand einer weiteren zeitlichen Darstellung des Verlaufs des ersten Sensorsignals S_FB1 und einem Verlauf des ersten, zweiten und dritten Steuersignals S_IN1, S_IN2 und S_IN3 wird in Figur 3 ein erstes Ausführungsbeispiel mit entsprechender Variation der eingeschalteten Schaltelemente dargestellt. Der zeitliche Verlauf des ersten Sensorsignals S_FB1 repräsentiert den Verlauf des ersten Laststroms I_L1. Die gemeinsame Last R_L ist wiederum als Glühlampe des Kraftfahrzeugs ausgebildet.

Zu dem Einschaltzeitpunkt t1 wird die vorgegebene gemeinsame Last R_L zunächst mittels der dritten Ansteuerkombination angesteuert, d. h., alle drei Schaltelemente T1, T2 und T3 sind zunächst eingeschaltet. Dadurch verringern sich die Werte des jeweiligen Sensorsignals derart, dass sie jeweils in dem vorgegebenen Wertebereich liegen. Wie in Figur 3 dargestellt liegt der Verlauf des ersten Sensorsignals S_FB1 nach dem Einschaltzeitpunkt t1 in dem ihm zugeordneten Wertebereich. Der Verlauf des zweiten und dritten Sensorsignals S_FB2 und S_FB3 sind im Wesentlichen analog zum Verlauf des ersten Sensorsignals S_FB1 ausgebildet.

Da zu einem Zeitpunkt t5 ein betragsmäßiges Unterschreiten des ersten unteren Grenzsensorsignalgrenzwert I_L_TH1 möglich ist, wird zu dem Zeitpunkt t5 das dritte Schaltelement T3 mittels des dritten Steuersignals S_IN3 ausgeschaltet. Die Werte der Sensorsignale der eingeschalteten Schaltelemente T1 und T2 steigen an und ein Unterschreiten des ersten unteren Grenzsensorsignalgrenzwert I_L_TH1 wird vermieden.

Zu einem Zeitpunkt t6 ist der Verlauf des ersten Sensorsignals S_FB1 auf den ersten vorgegebenen Sensorsignalwert I_FB1 eingeschwungen. Der erste Sensorsignalwert I_FB1 ist in Figur 3 dem Wertebereich des ersten Sensorsignals S_FB1 zugeordnet und stellt einen Wert des ersten Sensorsignals S_FB1 dar, der besonders genau und zuverlässig ermittelt werden kann.

Ab dem Zeitpunkt t6 kann der Verlauf des ersten Sensorsignals S_FB1 mittels kontinuierlicher und/oder periodischer Analog-Digital-Wandlung überwacht werden.

Da der Verlauf des ersten Sensorsignals S_FB1 ab dem Zeitpunkt t5 in dem ihm vorgegebenen Wertebereich liegt, ist ein Einschalten eines weiteren Schaltelementes, so z. B. des dritten Schaltelementes T3, für diese Ansteuerung der gemeinsamen Last R_L nicht notwendig.

Zum Betreiben der Glühlampe als vorgegebene gemeinsame Last R_L ist somit nach Figur 3 im Zeitabschnitt t1 bis t5 die dritte Ansteuerkombination von Schaltelementen erforderlich und im Zeitabschnitt ab dem Zeitpunkt t5 die zweite Ansteuerkombination erforderlich, damit die jeweiligen Werte des Sensorsignals in dem ihm vorgegebenen Wertebereich liegen.

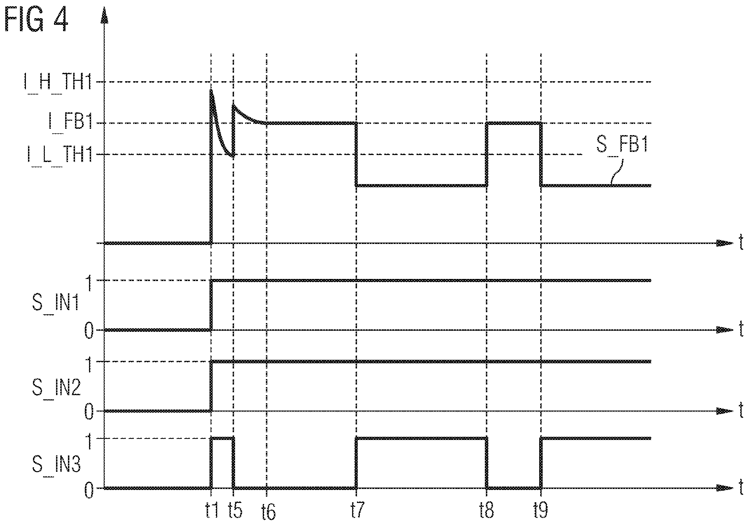

Anhand der Figur 4 wird ein weiteres Ausführungsbeispiel mittels einer weiteren zeitlichen Darstellung des Verlaufs des ersten Sensorsignals S_FB1 und einem Verlauf des ersten, zweiten und dritten Steuersignals S_IN1, S_IN2 und S_IN3 dargestellt.

Analog zur Figur 3 wird in Figur 4 zu dem Zeitpunkt t5 das dritte Schaltelement T3 ausgeschaltet und somit eine betragsmäßige Unterschreitung des ersten unteren Grenzsensorsignalgrenzwert I_L_TH1 vermieden. Das erste und zweite Schaltelement T1 und T2 sind entsprechend der zweiten Ansteuerkombination weiterhin eingeschaltet.

Analog zur Figur 3 ist in Figur 4 zu dem Zeitpunkt t6 der Verlauf des ersten Sensorsignals S_FB1 auf den ersten vorgegebenen Sensorsignalwert I_FB1 eingeschwungen.

Zu einem Zeitpunkt t7 wird die dritte Ansteuerkombination mittels der Ausführungseinheit EU vorgegeben und somit das dritte Schaltelement T3 mittels des dritten Steuersignals S_IN3 eingeschaltet. Ab diesem Zeitpunkt t7 resultiert der gemeinsame Laststrom I_L aus dem ersten, zweiten und dritten Laststrom I_L1, I_L2 und I_L3. Damit reduzieren sich die Werte des ersten Laststroms I_L1 betragsmäßig und somit auch die Werte des ersten Sensorsignals S_FB1. Die dritte Ansteuerkombination hat den Vorteil, dass jeweilige Innerwiderstände, so z. B. Drain-Source-Widerstände der jeweiligen Schalter, der Schaltelemente T1, T2 und T3 elektrisch parallel verkoppelt sind und somit der Wert des resultierenden Widerstands kleiner ist als der kleinste Wert der drei Innenwiderstände der Schaltelemente T1, T2 oder T3. Dadurch sinkt die Verlustleistung der Schaltungsanordnung, wodurch ein besonders effizienter Betrieb der gemeinsamen Last R_L gewährleistet werden kann. Zu einer genauen Ermittlung des jeweiligen Wertes des ersten Sensorsignals S_FB1 ist die dritte Ansteuerkombination allerdings nicht geeignet, weil der Verlauf des ersten Sensorsignals S_FB1 den ersten unteren Grenzsensorsignalwert I_L_TH1 betragsmäßig unterschreitet und somit eine Ermittlung des ersten Sensorsignals S_FB1 nur mit eingeschränkter Messgenauigkeit innerhalb dieses Zeitabschnittes möglich ist.

Zu einem Zeitpunkt t8 wird das dritte Schaltelement T3 mittels des ihm zugeordneten dritten Steuersignals S_IN3 wieder ausgeschaltet und somit erneut die zweite Ansteuerkombination vorgegeben. Zu einem Zeitpunkt t9 wird erneut die dritte Ansteuerkombination vorgegeben und somit das dritte Schaltelement T3 wieder eingeschaltet.

Innerhalb des Zeitabschnitts zwischen dem Zeitpunkt t8 und t9 steigen die Werte des ersten Sensorsignals S_FB1 erneut an und liegen in dem ihm vorgegebenen Wertebereich zwischen dem ersten unteren Grenzsensorsignalwert I_L_TH1 und dem ersten oberen Grenzsensorsignalgrenzwert I_H_TH1. Innerhalb dieses Zeitabschnitts kann das erste Sensorsignal S_FB1 erneut mit geeigneter Messgenauigkeit ermittelt werden und die vorgegebene gemeinsame Last R_L besonders genau überwacht werden.

Eine sich zeitlich abwechselnde Ansteuerung gemäß der zweiten und dritten Ansteuerkombination in Figur 4 ist besonders vorteilhaft, wenn eine Ermittlung des aktuellen Wertes des jeweiligen Sensorsignals nur für vorgegebene Zeitpunkte erforderlich ist und für die übrigen Zeitabschnitte eine Ermittlung des jeweiligen Sensorsignals nicht erforderlich ist. Die sich zeitlich abwechselnde Ansteuerung der zweiten und dritten Ansteuerkombination kombiniert besonders vorteilhaft eine genaue Ermittlung des jeweiligen Sensorsignals mit geeigneter Messgenauigkeit und eine besonders verlustleistungsarme Ansteuerung der gemeinsamen Last R_L. Besonders vorteilhaft kann die sich abwechselnde Ansteuerung gemäß der zweiten und dritten Ansteuerkombination der Schaltelemente periodisch erfolgen.

Die als Glühlampe ausgebildete vorgegebene gemeinsame Last R_L weist einen Verlauf des gemeinsamen Laststroms I_L auf, der in Figur 2 durch den Verlauf des ersten Sensorsignals S_FB1 repräsentiert wird. Wird ein derartiger Verlauf eines jeweiligen Sensorsignals ermittelt, kann diesem Verlauf des jeweiligen Sensorsignals eine Glühlampe als gemeinsame Last R_L zugeordnet werden. Somit repräsentiert ein derartiger Verlauf des jeweiligen Sensorsignals eine Glühlampe als gemeinsame Last R_L. Sind mehrere Glühlampen elektrisch parallel gekoppelt, addieren sich die jeweiligen Verläufe, sind aber weiterhin repräsentativ für die Glühlampen als gemeinsame Last R_L.

Damit eine gemeinsame Last R_L besonders sicher und zuverlässig erkannt werden kann, ist es zunächst erforderlich, den die gemeinsame Last R_L repräsentierenden Verlauf des jeweiligen Sensorsignals zu ermitteln und zu speichern. Besonders vorteilhaft ist es, wenn der jeweilige Verlauf des Sensorsignals in dem ihm vorgegebenen Wertebereich liegt und das Sensorsignal somit besonders genau ermittelt werden kann. Wie anhand der Figur 3 oder 4 dargestellt, sind nach dem Einschalten verschiedene Ansteuerkombinationen von eingeschalteten Schaltelementen erforderlich, um das jeweilige Sensorsignal dem ihm vorgegebenen Wertebereich zu zuordnen. Neben dem Verlauf des Sensorsignals wird bevorzugt auch zumindest eine Auswahl an eingeschalteten Schaltelementen ermittelt und gespeichert.

Die Ermittlung und Speicherung des Verlaufs des jeweiligen Sensorsignals und der dafür erforderlichen Ansteuerkombinationen der Schaltelemente kann bevorzugt mittels der Ausführungseinheit EU erfolgen.

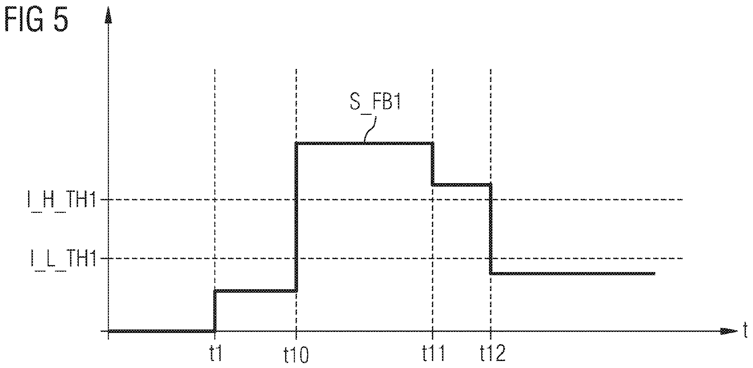

Anhand der Figur 5 ist ein zeitlicher Verlauf der ersten Ansteuerkombination dargestellt, wobei beispielsweise das erste Schaltelement T1 eingeschaltet ist und das zweite und dritte Schaltelement T2 und T3 ausgeschaltet sind. Der Verlauf des ersten Sensorsignals S_FB1 repräsentiert im Vergleich zur Figur 3 oder 4 einen gemeinsamen Laststrom I_L der vorgegebenen gemeinsamen Last R_L, die nun beispielsweise als Xenon-Leuchtmittel ausgebildet ist. Der Verlauf des ersten Sensorsignals S_FB1 ist im Wesentlichen stufenförmig ausgebildet.

Zu dem Einschaltzeitpunkt t1 steigt das den gemeinsamen Laststrom I_L repräsentierende erste Sensorsignal S_FB1, idealisiert dargestellt, an. Der Verlauf des ersten Sensorsignals S_FB1 entspricht beginnend zum Zeitpunkt t1 einem Verlauf eines Einschaltstroms der als Xenon-Leuchtmittel ausgebildeten gemeinsamen Last R_L.

Zu einem Zeitpunkt t10 steigt der Verlauf des ersten Sensorsignals S_FB1 erneut an. Zu einem Zeitpunkt t11 und einem Zeitpunkt t12 sinkt der Verlauf des ersten Sensorsignals S_FB1 ab, um ab dem Zeitpunkt t12 auf einen vorgegebenen Wert, der beispielsweise den Nennstrom des Xenon-Leuchtmittels repräsentiert, einzuschwingen.

Neben dem Verlauf des ersten Sensorsignals S_FB1 sind in Figur 5 auch der erste untere Grenzsensorsignalwert I_L_TH1 und der erste obere Grenzsensorsignalgrenzwert I_H_TH1 dargestellt. Der erste untere Grenzsensorsignalwert I_L_TH1 und der erste obere Grenzsensorsignalgrenzwert I_H_TH1 repräsentieren den vorgegebenen Wertebereich des ersten Sensorsignals S_FB1. Der vorgegebene Wertebereich wird im Wesentlichen von dem Verlauf des ersten Sensorsignals S_FB1 betragsmäßig unter- oder überschritten, so dass eine Ermittlung des ersten Sensorsignals S_FB1 nur mit eingeschränkter Messgenauigkeit möglich ist.

Um eine genaue Ermittlung des jeweiligen Sensorsignals zu ermöglichen, muss auch für die als Xenon-Leuchtmittel ausgebildete gemeinsame Last R_L zumindest eine Auswahl an eingeschalteten Schaltelementen ermittelt werden, damit das jeweilige Sensorsignal in dem ihm vorgegebenen Wertebereich liegt.

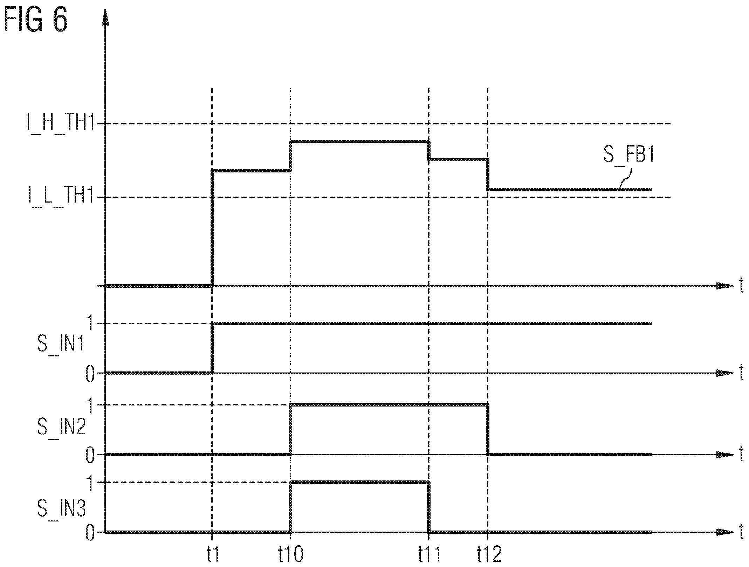

In Figur 6 ist ein zeitlicher Verlauf des ersten Sensorsignals S_FB1 dargestellt und ein Verlauf des ersten, zweiten und dritten Steuersignals S_IN1, S_IN2 und S_IN3.

Zu dem Einschaltzeitpunkt t1 wird zunächst die erste Ansteuerkombination vorgegeben, d. h. ein eingeschaltetes und zwei ausgeschaltete Schaltelemente. Zum Einschaltzeitpunkt t1 wird beispielsweise das erste Schaltelement T1 mittels des ersten Steuersignals S_IN1 eingeschaltet und das zweite und dritte Schaltelement T2 und T3 bleiben weiterhin ausgeschaltet. Das erste Sensorsignal S_FB1 steigt idealisiert dargestellt auf einen vorgegebenen Wert an, der in dem ihm vorgegebenen Wertebereich liegt und somit eine genaue und sichere Ermittlung des ersten Sensorsignals S_FB1 mit geeigneter Messgenauigkeit ermöglicht. Zu dem Zeitpunkt t10 wird die dritte Ansteuerkombination vorgegeben, d. h., zusätzlich werden das zweite und dritte Schaltelement T2 und T3 mittels des zweiten und dritten Steuersignals S_IN2 und S_IN3 eingeschaltet. Dadurch teilt sich der gemeinsame Laststrom I_L auf den ersten, zweiten und dritten Laststrom I_L1, I_L2 und I_L3 auf. Die Werte des ersten Sensorsignals S_FB1 sinken somit in dem Zeitabschnitt ab und liegen in dem vorgegebenen Wertebereich.

Zu dem Zeitpunkt t11 wird die zweite Ansteuerkombination vorgegeben, d. h., das dritte Schaltelement T3 wird beispielsweise mittels des dritten Steuersignals S_IN3 ausgeschaltet, so dass ab diesem Zeitpunkt t11 das erste und zweite Schaltelement T1 und T2 weiterhin eingeschaltet sind. Dadurch liegen die Werte des ersten Sensorsignals S_FB1 weiterhin in dem vorgegebenen Wertebereich, so dass auch hier eine genaue Ermittlung des ersten Sensorsignals S_FB1 gewährleistet ist.

Zu dem Zeitpunkt t12 wird erneut die erste Ansteuerkombination vorgegeben, d. h., das zweite Schaltelement T2 wird beispielsweise mittels des zweiten Steuersignals S_IN2 ausgeschaltet, so dass nur noch das erste Schaltelement T1 eingeschaltet ist. Ab dem Zeitpunkt t12 ist der gemeinsame Laststrom I_L eingeschwungen und das erste Sensorsignal S_FB1 repräsentiert zu dem Zeitpunkt t12 einen ersten Laststrom I_L1, der beispielsweise einen Nennstrom der gemeinsamen Last R_L repräsentiert.

Um eine genaue Ermittlung des Verlaufs des jeweiligen Sensorsignals und somit des ihm zugeordneten Laststroms zu gewährleisten, ist im Zeitabschnitt zwischen t1 und t10 die erste Ansteuerkombination, im Zeitabschnitt zwischen t10 und t11 die dritte Ansteuerkombination, im Zeitabschnitt zwischen t11 und t12 die zweite Ansteuerkombination und im Zeitabschnitt nach dem Zeitpunkt t12 erneut die erste Ansteuerkombination erforderlich.

Der Verlauf des ersten Sensorsignals S_FB1 im Zeitbereich zwischen dem Zeitpunkt t1 und dem Zeitpunkt t12 liegt im vorgegebenen Wertebereich und ist weiterhin repräsentativ für die als Xenon-Leuchtmittel ausgebildete gemeinsame Last R_L.

Auch hier wird der Verlauf des ersten Sensorsignals S_FB1 und die dafür erforderlichen Ansteuerkombinationen der eingeschalteten Schaltelemente mittels der Ausführungseinheit EU ermittelt und gespeichert.

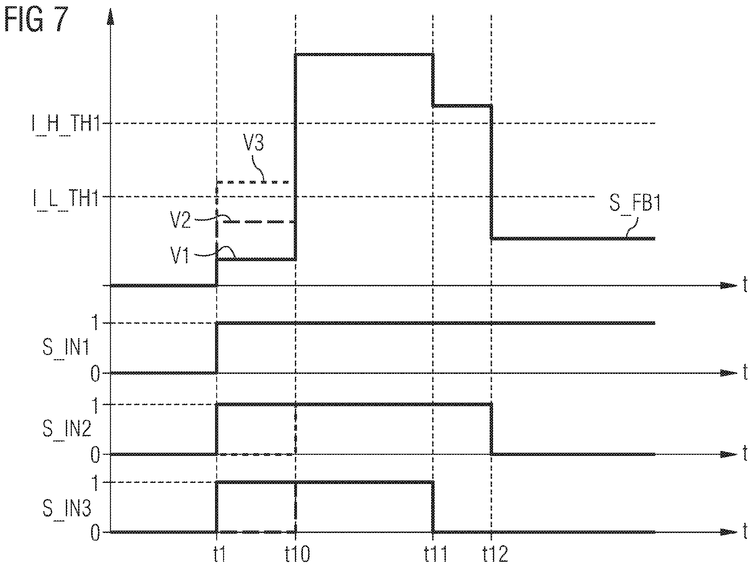

Anhand der Figur 7 wird eine Ermittlung des die gemeinsame Last R_L repräsentierenden Verlaufs des jeweiligen Sensorsignals, so z. B. des Verlaufs des ersten Sensorsignals S_FB1, erläutert. Dabei werden ein oder mehrere Ermittlungsdurchläufe mittels der Ausführungseinheit EU ausgeführt, um den Verlauf des jeweiligen Sensorsignals und die diesem Verlauf zugeordnete Ansteuerkombination der eingeschalteten Schaltelemente zu ermitteln und zu speichern.

In einem ersten Ermittlungsdurchlauf wird zu dem Einschaltzeitpunkt t1 zunächst die dritte Ansteuerkombination vorgegeben, d.h. das erste, zweite und dritte Schaltelement T1, T2 und T3 werd zum Einschaltzeitpunkt t1 eingeschaltet. Mittels der Ausführungseinheit EU wird ein erster Wert V1 des ersten Sensorsignals S_FB1 mit dem ersten unteren Grenzsensorsignalwerts I_L_TH1 verglichen und dabei eine betragsmäßige Unterschreitung des ersten unteren Grenzsensorsignalwerts I_L_TH1 ermittelt. Da die Werte des ersten Sensorsignals S_FB1 in diesem Zeitabschnitt nicht in dem ihm vorgegebenen Wertebereich liegen, wird der erste Ermittlungsdurchlauf bevorzugt hier gestoppt und alle Schaltelemente mittels der Steuersignale ausgeschaltet. Zu Optimierungszwecken ist es grundsätzlich auch möglich den ersten Ermittlungsdurchlauf weiter für die folgenden Zeitabschnitte auszuführen. Dies ist besonders dann vorteilhaft, wenn innerhalb eines nachfolgenden vorgegebenen Zeitabschnitts, wie beispielsweise zwischen den Zeitpunkten t10 und t11 die dritte Ansteuerkombination erforderlich ist, damit die Werte des jeweiligen Sensorsignals in dem ihm vorgegebenen Wertebereich liegen.

In einem zweiten Ermittlungsdurchlauf wird zu dem Einschaltzeitpunkt t1 bevorzugt die zweite Ansteuerkombination vorgegeben, so z. B. werden das erste und zweite Schaltelement T1 und T2 eingeschaltet. Das dritte Schaltelement T3 bleibt zunächst ausgeschaltet (siehe gestrichelte Darstellung des dritten Steuersignals S_IN3). Dieser zweiten Ansteuerkombination ist ein zweiter Wert V2 des ersten Sensorsignals S_FB1 (siehe gestrichelte Darstellung des ersten Sensorsignals S_FB1) zugeordnet. Auch dieser Wert wird mit dem ersten unteren Grenzsensorsignalwerts I_L_TH1 verglichen. Erneut wird eine betragsmäßige Unterschreitung des ersten unteren Grenzsensorsignalwerts I_L_TH1 ermittelt. Da auch mittels der zweiten Ansteuerkombination die Werte des ersten Sensorsignals S_FB1 nicht in dem ihm vorgegebenen Wertebereich liegen, wird auch hier der zweite Ermittlungsdurchlauf bevorzugt gestoppt und alle Schaltelemente mittels der Steuersignale ausgeschaltet. Auch hier es ist aufgrund von Optimierungszwecken denkbar, die zweite Ansteuerkombination weiter für nachfolgende Zeitabschnitte vorzugeben.

In einem dritten Ermittlungsdurchlauf wird nun die erste Ansteuerkombination vorgegeben, so z. B. wird nur das erste Schaltelement T1 eingeschaltet und das zweite und dritte Schaltelement T2 und T3 ausgeschaltet (siehe gestrichelte und gepunktete Darstellung des zweiten und dritten Steuersignals S_IN2 und S_IN3). Der ersten Ansteuerkombination ist ein dritter Wert V3 des ersten Sensorsignals S_FB1 (siehe gepunktete Darstellung des ersten Sensorsignals S_FB1) zugeordnet. Auch der dritte Wert V3 wird mittels der Ausführungseinheit EU mit dem ersten unteren Grenzsensorsignalwert I_L_TH1 verglichen. Zusätzlich kann der dritte Wert V3 auch mit dem ersten oberen Grenzsensorsignalwert I_H_TH1 verglichen werden, um eine mögliche Überschreitung des ersten oberen Grenzsensorsignalwert I_H_TH1 auszuschließen. Mittels der ersten Ansteuerkombination liegt der dritte Wert V3 des ersten Sensorsignals S_FB1 in dem ihm vorgegebenen Wertebereich. Somit ist eine Ermittlung des Sensorsignals S_FB1 in dem Zeitabschnitt zwischen t1 und t10 mit geeigneter Messgenauigkeit gewährleistet. Diesem Zeitabschnitt wird somit die erste Ansteuerkombination der Schaltelemente und der entsprechende Verlauf des ersten Sensorsignals S_FB1 zugeordnet und in der Ausführungseinheit EU gespeichert.

Da die Werte des ersten Sensorsignals S_FB1 mittels der ersten Ansteuerkombination in dem ihm vorgegebenen Wertebereich liegen, kann der dritte Ermittlungsdurchlauf für den folgenden Zeitabschnitt ausgeführt werden. Analog zum ersten Zeitabschnitt zwischen t1 und t10 kann in dem Zeitabschnitt zwischen t10 und t11 mittels der Ausführungseinheit EU erneut zunächst die dritte Ansteuerkombination der Schaltelemente vorgegeben werden. Alternativ kann aber auch mit der bereits anliegenden ersten Ansteuerkombination fortgefahren werden. Liegen die Werte des ersten Sensorsignals S_FB1 nicht in dem ihm vorgegebenen Wertebereich, wird die zweite Ansteuerkombination vorgegeben und liegen auch diese nicht im vorgegebenen Wertebereich wird als letztes die erste Ansteuerkombination vorgegeben.

Liegen auch nach der Anwendung aller möglichen Ansteuerkombinationen die Werte des jeweiligen Sensorsignals nicht in dem ihm vorgegebenen Wertebereich, kann beispielsweise angenommen werden, dass eine Ermittlung mit der vorhandenen Anzahl und Ausführung von Schaltelementen nur mit eingeschränkter Messgenauigkeit möglich ist und somit ein Betrieb der vorgegebenen gemeinsamen Last R_L nicht sicher gewährleistet ist. Alternativ kann eine weitere Ansteuerung der vorgegebenen gemeinsamen Last auch unterbrochen werden, um eine mögliche Schädigung zu vermeiden.

Bevorzugt kann also für den jeweiligen Zeitabschnitt die Ermittlung des Verlaufs des jeweiligen Sensorsignals und die Ermittlung der jeweiligen zugeordneten Ansteuerkombinationen derart erfolgen, dass zunächst die dritte, dann die zweite und zum Schluss die erste Ansteuerkombination ausgeführt wird. Grundsätzlich kann die Ermittlung auch derart erfolgen, dass zunächst die erste, danach die zweite und als Letztes die dritte Ansteuerkombination ausgeführt wird. Alternativ können aber auch beide Ermittlungsstrategien kombiniert werden. Grundsätzlich sind aber auch andere Ermittlungsstrategien zur Ermittlung der benötigten Ansteuerkombinationen denkbar.

Die mögliche Anzahl der Ansteuerkombinationen erhöht sich entsprechend bei mehr als drei Schaltelementen oder verringert sich bei weniger als drei Schaltelementen.

Werden mehr als drei Schaltelemente angesteuert kann die Ermittlung der benötigten Ansteuerkombinationen derart erfolgen, dass zunächst alle Schaltelemente eingeschaltet werden und mit jedem weiteren Ermittlungsdurchlauf ein Schaltelement ausgeschaltet wird, wenn die vorherige Ansteuerkombination nicht geeignet ist. Alternativ kann anfangs auch nur ein Schaltelement eingeschaltet werden und mit jedem weiteren benötigten Ermittlungsdurchlauf für den jeweiligen Zeitabschnitt ein weiteres Schaltelement eingeschaltet werden.

Die anhand der Figur 7 dargestellte Ermittlung und Speicherung der jeweiligen Ansteuerkombination und des dadurch resultierenden Verlaufs des jeweiligen Sensorsignals kann analog auch auf einen anderen Verlauf des jeweiligen Sensorsignals ausgeführt werden, so z. B. auf den die Glühlampe repräsentierenden Verlauf des ersten Sensorsignals S_FB1 wie in Figur 3 und 4 dargestellt.

Ist beispielsweise eine unbekannte gemeinsame Last R_L mit den Schaltelementen T1, T2 und T3 gekoppelt, so kann bevorzugt mittels eines Vergleichs mit den gespeicherten Verläufen des jeweiligen Sensorsignals auf die gemeinsame Last R_L geschlossen werden.

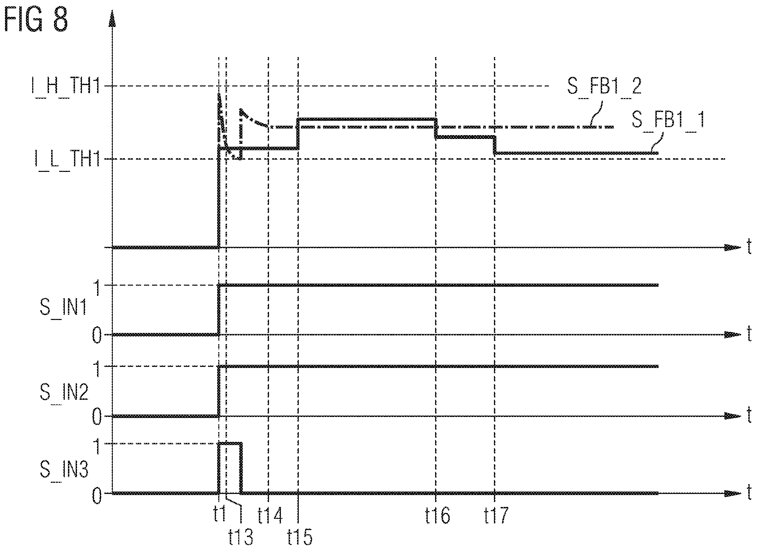

Ausgehend davon, dass Ansteuerkombinationen und ein Verlauf eines Sensorsignals für eine Glühlampe, sowie Ansteuerkombinationen und ein weiterer Verlauf eines Sensorsignals für ein Xenon-Leuchtmittel mittels der Ausführungseinheit EU ermittelt und gespeichert sind, wird anhand der Figur 8 die Erkennung der gemeinsamen Last R_L näher erläutert.

Die Figur 8 stellt einen ersten gespeicherten Verlauf S_FB1_1 des ersten Sensorsignals S_FB1 dar, der repräsentativ ist für eine gemeinsame Last R_L, die als Xenon-Leuchtmittel ausgebildet ist. Ferner stellt die Figur 8 einen zweiten gespeicherten Verlauf S_FB1_2 des ersten Sensorsignals S_FB1 dar, der repräsentativ ist für eine gemeinsame Last R_L, die als Glühlampe ausgebildet ist. Der erste und zweite gespeicherte Verlauf S_FB1_1 und S_FB1_2 des ersten Sensorsignals S_FB1 sind bevorzugt in der Ausführungseinheit EU gespeichert.

Wird nun eine unbekannte gemeinsame Last (nicht dargestellt in Figur 8) mit den Schaltelementen gekoppelt, so wird zu dem Einschaltzeitpunkt t1 beispielsweise die dritte Ansteuerkombination vorgegeben, d. h. das erste, zweite und dritte Schaltelement T1, T2 und T3 sind eingeschaltet. Zu einem Zeitpunkt t13 wird mittels einer Analog-Digital-Wandlung beispielsweise der aktuelle Wert des ersten Sensorsignals S_FB1 ermittelt. Liegt der ermittelte Wert des ersten Sensorsignals S_FB1 in dem ihm vorgegebenen Wertebereich, wird dieser mit den in der Ausführungseinheit EU dem Zeitpunkt t13 zugeordneten gespeicherten Werten der gespeicherten Verläufe verglichen, die einer dritten Ansteuerkombination zugeordnet sind. Beispielsweise wird der ermittelte Wert des ersten Sensorsignals S_FB1 mit einem dem Zeitpunkt t13 zugeordneten Wert des ersten gespeicherten Verlaufs S_FB1_1 verglichen, weil nur diesem Verlauf zu dem Zeitpunkt t13 die dritte Ansteuerkombination zugeordnet ist. Liegt der ermittelte Wert des ersten Sensorsignals S_FB1 betragsmäßig im Bereich des dem Zeitpunkt t13 zugeordneten Werts des ersten gespeicherten Verlaufs S_FB1_1, kann bevorzugt davon ausgegangen werden, dass die gemeinsame Last R_L als Glühlampe ausgebildet ist.

Liegt der ermittelte Wert des ersten Sensorsignals S_FB1 dagegen nicht in dem ihm zugeordneten Wertebereich, kann davon ausgegangen werden, dass die gemeinsame Last R_L als Xenon-Leuchtmittel ausgebildet ist, weil nur bei dieser der Wert des Sensorsignals nicht im vorgegebenen Wertebereich liegt während einer Ansteuerung gemäß der dritten Ansteuerkombination. Grundsätzlich sind auch andere dem Fachmann bekannte Erkennungsstrategien der gemeinsamen Last denkbar.

Im weiteren Betrieb der als Glühlampe erkannten gemeinsamen Last R_L werden die der Glühlampe zugeordneten gespeicherten Ansteuerkombinationen ausgeführt, so dass der Verlauf des ersten Sensorsignals S_FB1 in dem ihm vorgegebenen Wertebereich liegt und eine Ermittlung des ersten Sensorsignals S_FB1 mit geeigneter Messgenauigkeit gewährleistet ist.

Um eine besonders sichere Ermittlung der gemeinsamen Last R_L gewährleisten zu können, können ein oder mehrere weitere Ermittlungen des ersten Sensorsignals S_FB1 erfolgen, so z. B. zu einem weiteren Zeitpunkten t14. Stimmt beispielsweise der ermittelte Wert mit dem zu diesem Zeitpunkt zugeordneten gespeicherten Wert des zweiten gespeicherten Verlaufs S_FB1_2 des ersten Sensorsignals S_FB1 überein, kann mit einer besonders hohen Sicherheit die Glühlampe als gemeinsame Last R_L zugeordnet werden.

Grundsätzlich kann zur Erkennung der jeweiligen gemeinsamen Last R_L auch derart verfahren werden, dass zunächst mit derjenigen Ansteuerkombination zum Einschaltzeitpunkt t1 begonnen wird, die der letzten angesteuerten gemeinsamen Last R_L zugeordnet ist. Wurde beispielsweise während der letzten Ansteuerung ein Xenon-Leuchtmittel als gemeinsame Last R_L mittels der Schaltelemente angesteuert, so wird zum Einschaltzeitpunkt t1 mit einer Ansteuerkombination begonnen, die dem Einschaltzeitpunkt t1 und dem Xenon-Leuchtmittel zugeordnet ist.

Grundsätzlich ist es ferner denkbar, die bisher betriebenen gemeinsamen Lasten R_L statistisch zu ermitteln und abhängig von einer daraus resultierenden Wahrscheinlichkeit, dass die aktuelle gemeinsame Last R_L mit den Schaltelementen gekoppelt ist, eine vorgegebene Ansteuerkombination auszuwählen.

Neben der Verwendung von einer oder mehreren gleichen Lasten als vorgegebene gemeinsame Last R_L, so z. B. mehrere Glühlampen oder mehrere Xenon-Leuchtmittel, ist es auch denkbar eine Kombination verschiedener Lasten als gemeinsame Last R_L an die Schaltelemente zu koppeln. Somit kann die gemeinsame Last R_L beispielsweise zumindest eine Glühlampe und zumindest ein Xenon-Leuchtmittel aufweisen.

Neben der Ermittlung und Speicherung der zumindest einen Ansteuerkombination und dem daraus resultierenden Verlauf des jeweiligen Sensorsignals, kann die zumindest eine Ansteuerkombination und der Verlauf des jeweiligen Sensorsignals vorgegeben sein und bereits in der Ausführungseinheit gespeichert sein. Dadurch ist eine vorherige Ermittlung der zumindest einen Ansteuerkombination und der Verlauf des jeweiligen Sensorsignals nicht erforderlich.

## Patentansprüche

1. Verfahren zum Betreiben einer Schaltungsanordnung mit mehreren Schaltelementen (T1, T2, T3), die ausgangsseitig zumindest einer vorgegebenen gemeinsamen Last (R_L) zugeordnet sind und jeweils dazu ausgebildet sind, abhängig von einer Schaltstellung ein Nutzsignal (I_L1, I_L2, I_L3) an einem Ausgang (OUT1, OUT2, OUT3) des jeweiligen Schaltelements der zumindest einen gemeinsamen Last (R_L) zur Verfügung zu stellen, bei dem
- in einem oder mehreren Ermittlungsdurchläufen zumindest eine Auswahl an eingeschalteten Schaltelementen (T1, T2, T3) zur Ansteuerung der zumindest einen gemeinsamen Last (R_L) so lange verändert wird, bis ein dem jeweiligen Schaltelement (T1, T2, T3) zugeordnetes Sensorsignal (S_FB1, S_FB2, S_FB3), das repräsentativ ist für das Nutzsignal (I_L1, I_L2, I_L3) des jeweiligen Schaltelements (T1, T2, T3), in einem ihm vorgegebenen Wertebereich (I_L_TH1, I_H_TH1) liegt,
- diejenige zumindest eine Auswahl an eingeschalteten Schaltelementen (T1, T2, T3) ermittelt wird, bei der das jeweilige Sensorsignal (S_FB1, S_FB2, S_FB3) in dem ihm vorgegebenen Wertebereich (I_L_TH1, I_H_TH1) liegt, **dadurch gekennzeichnet, dass** die ermittelte Auswahl an eingeschalteten Schaltelementen (T1, T2, T3) gespeichert wird.

2. Verfahren nach Anspruch 1, bei dem diejenige zumindest eine Auswahl an eingeschalteten Schaltelementen (T1, T2, T3) ermittelt und gespeichert wird, die einem vorgegebenen Zeitabschnitt bezüglich eines Startzeitpunkts (t1) der Ansteuerung der Schaltelemente (T1, T2, T3) zugeordnet ist.

3. Verfahren nach Anspruch 1 oder 2, bei dem die zumindest eine Auswahl an eingeschalteten Schaltelementen (T1, T2, T3) derart ermittelt wird, dass während eines ersten Ermittlungsdurchlaufs zunächst alle Schaltelemente (T1, T2, T3) eingeschaltet sind und das jeweilige Sensorsignal (S_FB1, S_FB2, S_FB3) mit dem ihm vorgegebenen Wertebereich verglichen wird und bei einem betragsmäßigen Unterschreiten des vorgegebenen Wertebereichs (I_L_TH1, I_H_TH1) in zumindest einem weiteren Ermittlungsdurchlauf eine jeweilige Untermenge der Schaltelemente (T1, T2, T3) ausgeschaltet wird, bis das jeweilige Sensorsignal (S_FB1, S_FB2, S_FB3) in dem ihm vorgegebenen Wertebereich (I_L_TH1, I_H_TH1) liegt.

4. Verfahren nach einem der vorstehenden Ansprüche, bei dem die zumindest eine Auswahl an eingeschalteten Schaltelementen (T1, T2, T3) derart vorgegeben wird, dass während eines ersten Ermittlungsdurchlaufs zunächst ein Schaltelement eingeschaltet ist und das jeweilige Sensorsignal (S_FB1, S_FB2, S_FB3) mit dem ihm vorgegebenen Wertebereich (I_L_TH1, I_H_TH1) verglichen wird und bei einem betragsmäßigen Überschreiten des vorgegebenen Wertebereichs (I_L_TH1, I_H_TH1) in zumindest einem weiteren Ermittlungsdurchlauf eine jeweilige Untermenge der Schaltelemente (T1, T2, T3) eingeschaltet wird, bis das jeweilige Sensorsignal (S_FB1, S_FB2, S_FB3) in dem ihm vorgegebenen Wertebereich (I_L_TH1, I_H_TH1) liegt.

5. Verfahren nach einem der vorstehenden Ansprüche, bei dem ein der jeweiligen Auswahl an eingeschalteten Schaltelementen (T1, T2, T3) zugeordneter Verlauf des jeweiligen Sensorsignals (S_FB1, S_FB2, S_FB3) ermittelt und gespeichert wird, der repräsentativ ist für die zumindest eine vorgegebene gemeinsame Last (R_L).

6. Verfahren nach einem der vorstehenden Ansprüche, bei dem ein aktuell ermittelter Verlauf des Sensorsignals (S_FB1, S_FB2, S_FB3) mit einem gespeicherten Verlauf des Sensorsignals (S_FB1, S_FB2, S_FB3) verglichen wird, wobei der gespeicherte Verlauf des Sensorsignals (S_FB1, S_FB2, S_FB3) repräsentativ ist für die zumindest eine vorgegebene gemeinsame Last (R_L), und abhängig von dem Vergleich die zumindest eine vorgegebene gemeinsame Last (R_L) erkannt wird.

7. Schaltungsanordnung mit mehreren Schaltelementen (T1, T2, T3), die ausgangsseitig zumindest einer vorgegebenen gemeinsamen Last (R_L) zugeordnet sind und jeweils dazu ausgebildet sind, abhängig von einer Schaltstellung ein Nutzsignal (I_L1, I_L2, I_L3) an einem Ausgang (OUT1, OUT2, OUT3) des jeweiligen Schaltelements (T1, T2, T3) der zumindest einen gemeinsamen Last (R_L) zur Verfügung zu stellen, wobei die Schaltungsanordnung dazu ausgebildet ist
- in einem oder mehreren Ermittlungsdurchläufen zumindest eine Auswahl an eingeschalteten Schaltelementen (T1, T2, T3) zur Ansteuerung der zumindest einen gemeinsamen Last (R_L) so lange zu verändern, bis ein dem jeweiligen Schaltelement (T1, T2, T3) zugeordnetes Sensorsignal (S_FB1, S_FB2, S_FB3), das repräsentativ ist für das Nutzsignal (I_L1, I_L2, I_L3) des jeweiligen Schaltelements (T1, T2, T3), in einem ihm vorgegebenen Wertebereich (I_L_TH1, I_H_TH1) liegt,
- diejenige zumindest eine Auswahl an eingeschalteten Schaltelementen (T1, T2, T3) zu ermitteln, bei der das jeweilige Sensorsignal (S_FB1, S_FB2, S_FB3) in dem ihm vorgegebenen Wertebereich (I_L_TH1, I_H_TH1) liegt, **dadurch gekennzeichnet, dass** die Schaltungsanordnung dazu ausgebildet ist, die ermittelte Auswahl an eingeschalteten Schaltelementen (T1, T2, T3) zu speichern.

## Claims

1. Method for operating a circuit arrangement having a plurality of switching elements (T1, T2, T3) which are assigned on the output side to at least one predefined common load (R_L) and are each designed to make available, as a function of a switched position, a user signal (I_L1, I_L2, I_L3) at an output (OUT1, OUT2, OUT3) of the respective switched element of the at least one common load (R_L), in which
- at least one selection of switched-on switching elements (T1, T2, T3) for actuating the at least one common load (R_L) is changed in one or more determination steps until a sensor signal (S_FB1, S_FB2, S_FB3) which is assigned to the respective switching element (T1, T2, T3) and is representative of the user signal (I_L1, I_L2, I_L3) of the respective switching element (T1, T2, T3) is in a value range (I_L_TH1, I_H_TH1) predefined for it,
- that at least one selection of switched-on switching elements (T1, T2, T3) in which the respective sensor signal (S_FB1, S_FB2, S_FB3) is in the value range (I_L_TH1, I_H_TH1) predefined for it is determined **characterized in that** the determined selection of switched-on switching elements (T1, T2, T3) is saved.

2. Method as claimed in Claim 1, in which that at least one selection of switched-on switching elements (T1, T2, T3) which is assigned to a predefined time segment with respect to a starting time (t1) of the actuation of the switching elements (T1, T2, T3) is determined and saved.

3. Method as claimed in Claim 1 or 2, in which the at least one selection of switched-on switching elements (T1, T2, T3) is determined in such a way that during a first determination step at first all the switching elements (T1, T2, T3) are switched on and the respective sensor signal (S_FB1, S_FB2, S_FB3) is compared with the value range predefined for it, and if the predefined value range (I_L_TH1, I_H_TH1) is undershot in absolute terms in at least one further determination step, a respective subset of the switching elements (T1, T2, T3) is switched off until the respective sensor signal (S_FB1, S_FB2, S_FB3) is in the value range (I_L_TH1, I_H_TH1) predefined for it.

4. Method as claimed in one of the preceding claims, in which the at least one selection of switched-on switching elements (T1, T2, T3) is predefined in such a way that during a first determination step at first one switching element is switched on and the respective sensor signal (S_FB1, S_FB2, S_FB3) is compared with the value range (I_L_TH1, I_H_TH1) predefined for it, and if the predefined value range (I_L_TH1, I_H_TH1) is exceeded in absolute terms in at least one further determination step, a respective subset of the switching elements (T1, T2, T3) is switched on until the respective sensor signal (S_FB1, S_FB2, S_FB3) is in the value range (I_L_TH1, I_H_TH1) predefined for it.

5. Method as claimed in one of the preceding claims, in which a profile of the respective sensor signal (S_FB1, S_FB2, S_FB3) which is assigned to the respective selection of switched-on switching elements (T1, T2, T3) and is representative of the at least one predefined common load (R_L) is determined and saved.

6. Method as claimed in one of the preceding claims, in which a currently determined profile of the sensor signal (S_FB1, S_FB2, S_FB3) is compared with a saved profile of the sensor signal (S_FB1, S_FB2, S_FB3), wherein the saved profile of the sensor signal (S_FB1, S_FB2, S_FB3) is representative of the at least one predefined common load (R_L) and the at least one predefined common load (R_L) is detected as a function of the comparison.

7. Circuit arrangement having a plurality of switching elements (T1, T2, T3) which are assigned on the output side to at least one predefined common load (R_L) and are each designed to make available, as a function of a switched position, a user signal (I_L1, I_L2, I_L3) at an output (OUT1, OUT2, OUT3) of the respective switching element (T1, T2, T3) of the at least one common load (R_L), wherein the circuit arrangement is designed
- to change at least one selection of switched-on switching elements (T1, T2, T3) for actuating the at least one common load (R_L) in one or more determination steps until a sensor signal (S_FB1, S_FB2, S_FB3) which is assigned to the respective switching element (T1, T2, T3) and is representative of the user signal (I_L1, I_L2, I_L3) of the respective switching element (T1, T2, T3) is in a value range (I_L_TH1, I_H_TH1) predefined for it,
- to determine that at least one selection of switched-on switching elements (T1, T2, T3) in which the respective sensor signal (S_FB1, S_FB2, S_FB3) is in the value range (I_L_TH1, I_H_TH1) predefined for it, **characterized in that** the circuit arrangement is designed to save the determined selection of switched-on switching elements (T1, T2, T3).

## Revendications

1. Procédé pour faire fonctionner un circuit comportant plusieurs éléments de commutation (T1, T2, T3) qui sont associés, côté sortie, à au moins une charge commune (R_L) prédéfinie et sont respectivement conçus pour délivrer à l'au moins une charge commune (R_L), en fonction d'une position de commutation, un signal utile (I_L1, I_L2, I_L3) à une sortie (OUT1, OUT2, OUT3) de l'élément de commutation respectif, dans lequel
- au moins une sélection d'éléments de commutation (T1, T2, T3) activés est modifiée au cours d'un ou de plusieurs cycles de détermination afin de commander l'au moins une charge commune (R_L) jusqu'à ce qu'un signal de capteur (S_FB1, S_FB2, S_FB3) associé à l'élément de commutation (T1, T2, T3) respectif et représentatif du signal utile (I_L1, I_L2, I_L3) de l'élément de commutation (T1, T2, T3) respectif, se situe dans une plage de valeurs (I_L_TH1, I_H_TH1) qui lui est prédéfinie,
- l'au moins une sélection d'éléments de commutation (T1, T2, T3) activés, pour laquelle le signal de capteur (S_FB1, S_FB2, S_FB3) respectif se situe dans la plage de valeurs (I_L_TH1, I_H_TH1) qui lui est prédéfinie, est déterminée,
**caractérisé en ce que** la sélection déterminée d'éléments de commutation (T1, T2, T3) activés est mémorisée.

2. Procédé selon la revendication 1, dans lequel l'au moins une sélection d'éléments de commutation (T1, T2, T3) activés, qui est associée à une période de temps prédéfinie par rapport à un point de départ (t1) de la commande des éléments de commutation (T1, T2, T3), est déterminée et mémorisée.

3. Procédé selon la revendication 1 ou 2, dans lequel l'au moins une sélection d'éléments de commutation (T1, T2, T3) activés est déterminée de manière à ce que, au cours d'un premier cycle de détermination, tous les éléments de commutation (T1, T2, T3) soient initialement activés et à ce que le signal de capteur (S_FB1, S_FB2, S_FB3) respectif soit comparé à la plage de valeurs prédéfinie et, si sa valeur s'abaisse en dessous de la plage de valeurs (I_L_TH1, I_H_TH1) prédéfinie, un sous-ensemble respectif des éléments de commutation (T1, T2, T3) soit désactivé au cours d'au moins un autre cycle de détermination jusqu'à ce que le signal de capteur (S_FB1, S_FB2, S_FB3) respectif se situe dans la plage de valeurs (I_L_TH1, I_H_TH1) qui lui est prédéfinie.

4. Procédé selon l'une des revendications précédentes, dans lequel l'au moins une sélection d'éléments de commutation (T1, T2, T3) activés est prédéfinie de manière à ce qu'un élément de commutation soit initialement activé au cours d'un premier cycle de détermination et le signal de capteur (S_FB1, S_FB2, S_FB3) respectif est comparé à la plage de valeurs (I_L_TH1, I_H_TH1) prédéfinie et, lorsque sa valeur dépasse la plage de valeurs (I_L_TH1, I_H_TH1) prédéfinie, un sous-ensemble respectif des éléments de commutation (T1, T2, T3) est activé au cours d'au moins un autre cycle de détermination jusqu'à ce que le signal de capteur (S_FB1, S_FB2, S_FB3) respectif se situe dans la plage de valeurs (I_L_TH1, IH_TH1) qui lui est prédéfinie.

5. Procédé selon l'une des revendications précédentes, dans lequel un cycle du signal de capteur (S_FB1, S_FB2, S_FB3) respectif associé à la sélection respective d'éléments de commutation (T1, T2, T3) activés, qui est représentatif de l'au moins une charge commune (R_L) prédéfinie, est déterminé et mémorisé.

6. Procédé selon l'une des revendications précédentes, dans lequel un cycle actuellement déterminé du signal de capteur (S_FB1, S_FB2, S_FB3) est comparé à un cycle mémorisé du signal de capteur (S_FB1, S_FB2, S_FB3), dans lequel le cycle mémorisé du signal de capteur (S_FB1, S_FB2, S_FB3) est représentatif de l'au moins une charge commune (R_L) prédéfinie, et l'au moins une charge commune (R_L) prédéfinie est détectée en fonction de la comparaison.

7. Système de circuit comportant plusieurs éléments de commutation (T1, T2, T3) qui sont associés, côté sortie, à au moins une charge commune (R_L) prédéfinie et sont respectivement conçus pour délivrer à l'au moins charge commune (R_L), en fonction d'une position de commutation, un signal utile (I_L1, I_L2, I_L3) à une sortie (OUT1, OUT2, OUT3) de l'élément de commutation (T1, T2, T3) respectif, dans lequel le système de circuit est conçu
- pour modifier au moins une sélection d'éléments de commutation (T1, T2, T3) activés au cours d'un ou de plusieurs cycles de détermination afin de commander l'au moins une charge commune (R_L) jusqu'à ce qu'un signal de capteur (S_FB1, S_FB2, S_FB3) associé à l'élément de commutation (T1, T2, T3) respectif et représentatif du signal utile (I_L1, I_L2, I_L3) de l'élément de commutation (T1, T2, T3) respectif, se situe dans une plage de valeurs (I_L_TH1, I_H_TH1) qui lui est prédéfinie,
- pour déterminer l'au moins une sélection d'éléments de commutation (T1, T2, T3) activés, pour laquelle le signal du capteur (S_FB1, S_FB2, S_FB3) respectif se situe dans la plage de valeurs (I_L_TH1, I_H_TH1) qui lui est prédéfinie,
**caractérisé en ce que** le système de circuit est conçu pour mémoriser la sélection déterminée d'éléments de commutation (T1, T2, T3) activés.
